# EUROPEAN PATENT SPECIFICATION

(11) **EP 3 166 222 B1**
(45) Date of publication and mention of the grant of the patent: **10.05.2023**
(21) Application number: 16197335.9
(22) Date of filing: 04.11.2016
(51) Int. Cl.: H02S 40/34

(54) **PHOTOVOLTAIC JUNCTION BOX**
PHOTOVOLTAIKANSCHLUSSKASTEN
BOÎTE DE JONCTION PHOTOVOLTAÏQUE

(30) Priority: 06.11.2015 CN 201510750599
(43) Date of publication of application: 10.05.2017
(73) Proprietor: Tyco Electronics (Shanghai) Co., Ltd., Pilot Free Trade Zone Shanghai (CN)
(72) Inventor: LI, Cui, Caohejing, Shanghai 200233 (CN); LV, Wenbo, Caohejing, Shanghai 200233 (CN); XU, Xiang, Caohejing, Shanghai 200233 (CN)
(74) Representative: Grünecker Patent- und Rechtsanwälte PartG mbB

(56) References cited:
- CN-A- 103 187 383
- US-A1- 2012 205 149
- US-A1- 2012 224 339
- US-A1- 2013 087 899

## Description

### BACKGROUND OF THE INVENTION

### Field of the Invention

The present invention relates to a photovoltaic junction box adapted to be mounted on a solar panel

### Description of the Related Art

Solar panel (or referred as solar cell panel) is a device for collecting solar energy and converting solar energy into electrical energy.

When the solar panel is shaded by cloud or leaves, a shadow region is formed on the solar panel, and the shaded solar panel will produce the hot spot effect, which will lead to the solar panel burned. In order to prevent the solar panel from being burned due to the hot spot effect, it is necessary to provide bypass diodes in the photovoltaic junction box.

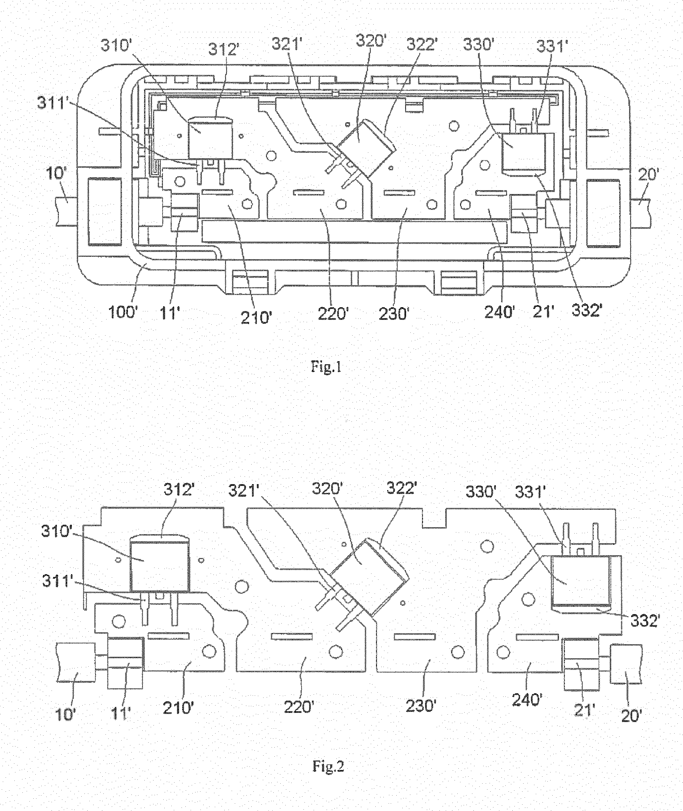

Fig.1 is an illustrative perspective view of a photovoltaic junction box in the prior art. Fig.2 shows four terminals 210', 220', 230', 240' and three diodes 310', 320', 330' arranged in the photovoltaic junction box of Fig.1.

As shown in Figs.1-2, in the prior art, the photovoltaic junction box mainly comprise a box body 100', and four terminals 210', 220', 230', 240' and three diodes 310', 320', 330' arranged in the box body 100'. Each three diode 310', 320', 330' is mounted between adjacent terminals 210', 220', 230', 240'.

As shown in Figs.1-2, in the prior art, a conductor core 11' of a positive wire 10' introduced into the box body 100' is directly electrically connected to the terminal 210', and a conductor core 21' of a negative wire 20' introduced into the box body 100' is directly electrically connected to the terminal 240'.

As shown in Figs.1-2, in the prior art, each three diode 310', 320', 330' comprises a positive pin 311', 321', 331' and a negative pin 312', 322', 332' soldered on the adjacent two terminals, respectively. An area of a soldering bottom surface of each negative pin 312', 322', 332' is larger than that of a soldering bottom surface of each positive pin 311', 321', 331'.

As shown in Figs.1-2, in the prior art, the positive pin 311' of the diode 310' is soldered on the terminal 210' . The negative pin 312' of the diode 310' is soldered on the terminal 220'. A chip (not shown, which is packaged in a package body) for the diode 310' is directly soldered on a top surface of the negative pin 312' of the diode 310'. Since the area of the soldering bottom surface of the negative pin 312' of the diode 310' is larger than that of the soldering bottom surface of the positive pin 311' of the diode 310', the heat generated by the chip for the diode 310' in use is mostly transferred to the terminal 220' via the negative pin 312'. Because the terminal 220' is not directly connected to the conductor 11' of the positive wire 10', the heat transferred to the terminal 220' cannot be rapidly dissipated to the external of the box body 100'. It will lead to the diode 310' burned due to overheat. Once the diode 310' is damaged, the diode 310' cannot play a bypass role, and the solar panel will be burned due to the hot spot effect.

US 2012/224339 A1 discloses a terminal box for a solar cell module which has a plurality of terminal boards. A bypass diode is connected between corresponding terminal boards and serves as a bypass for a reverse load. A box main body houses the bypass diode and the terminal boards and has an opening. A cover is fit to the box main body to cover the opening and has a protrusion on the back surface. An insulating resin is introduced into the box main body before the cover is fit to the box main body and has a recess the surface of which contacts the outer surface of the protrusion after the cover is fit to the box main body.

US 2013/087899 A1 discloses diode cell modules for use within photovoltaic systems, including lead frames including first leads extending from the first outlet terminal, second leads spaced from the first leads, second outlet terminals extending from the second leads, and diodes. In some examples, first leads define base portions connected to the first outlet terminal and diode portions extending from the base portions transverse to the first outlet terminal. In some examples, second leads may define a base portion and diode portions extending from the base portion substantially parallel to the diode portion of the first lead. In some examples, diodes may be in electrical contact with the diode portion of the first lead and with the diode portion of the second lead. In some examples, the first leads and second leads may be thermally conductive. In some examples, diodes may define die interfaces that are substantially fully engaged with diode portions of leads.

US 2012/205149 A1 discloses a photovoltaic junction box that comprises a housing that has at least first and second sides and the second side has at least one heat dissipating component. A conductor plate is received in the housing. The conductor plate supports at least one heat emitting component and at least one heat conducting component corresponding to the heat dissipating component of the housing. A mounting flange extends from the second side of the housing. At least a first gap is located between the second side of the housing and the mounting flange. The gap creates an air channel that allows air to flow between the housing and the mounting flange.

CN 103 187 383 A discloses a package structure of a Schottky diode, comprising a chip, a jumper wire and a metal frame, wherein the metal frame comprises a base metal frame and two lead-out metal frames which are arranged opposite to each other at intervals; the lower surface of the chip is welded with the upper surface of the base metal frame; the upper surface of the chip is welded with one end of the jumper wire; the other end of the jumper wire is welded on the upper surfaces of the lead-out metal frames; plastic packaging bodies are wrapped between the base metal frame and the lead-out metal frames, above the base metal frame and the lead-out metal frames and above and at the periphery of the chip and the jumper wire; the lower surfaces of the base metal frame and the lead-out metal frames are exposed outside the plastic package bodies; and pins extend from the base metal frame and the lead-out metal frames and positioned outside the plastic package bodies. The package structure of the Schottky diode has the beneficial effects that the heat-dissipating efficiency is high; the reliability is improved; the service life is prolonged; and the quality is improved.

### SUMMARY OF THE INVENTION

The present invention according to claim 1 has been made to overcome or alleviate at least one aspect of the above mentioned disadvantages.

According to an object of the present invention, there is provided a photovoltaic junction box, in which the heat generated by diodes in use may be rapidly dissipated to external of a box body, improving the heat dissipation performance, the current carrying capacity and the reliability of the photovoltaic junction box.

According to the present invention, each of the three diodes in the photovoltaic junction box is configured to be a surface mount type diode.

According to the present invention, the chip of the first diode is directly soldered on a top surface of the positive pin of the first diode.

According to the present invention, the four terminals further comprise a third terminal adjacent to the second terminal; and the three diodes further comprise a second diode mounted on the second terminal and the third terminal.

According to the present invention, the second diode comprises a chip, a positive pin soldered on the second terminal and a negative pin soldered on the third terminal; an area of a soldering bottom surface of the positive pin of the second diode soldered onto a surface of the second terminal is less than an area of a soldering bottom surface of the negative pin of the second diode soldered onto a surface of the third terminal; and the chip of the second diode is directly electrically connected to the negative pin of the second diode.

According to the present invention, an area of the third terminal is larger than that of the second terminal.

According to another exemplary embodiment of the present invention, an area of the third terminal is larger than that of any other one of the terminals in the photovoltaic junction box.

According to the present invention, the four terminals further comprise a fourth terminal adjacent to the third terminal; the three diodes further comprise a third diode mounted on the third terminal and the fourth terminal; a negative wire directed into the box body is electrically connected to the fourth terminal.

According to the present invention, the third diode comprises a chip, a positive pin soldered on the third terminal and a negative pin soldered on the fourth terminal; an area of a soldering bottom surface of the positive pin of the third diode soldered onto a surface of the third terminal is less than an area of a soldering bottom surface of the negative pin of the third diode soldered onto a surface of the fourth terminal; the chip of the third diode is directly electrically connected to the negative pin of the third diode.

According to another exemplary embodiment of the present invention, an area of the fourth terminal is substantially equal to that of the first terminal.

According to an aspect not part of the present invention, there is provided a diode, comprising: a chip having a positive surface and a negative surface; a package body packaged on the chip; a positive pin provided on the bottom of the package body and electrically connected to the positive surface of the chip; and a negative pin electrically connected to the negative surface of the chip and extending out from a side of the package body, wherein the chip is directly electrically connected to the positive pin, and an area of a soldering bottom surface of the positive pin is larger than that of a soldering bottom surface of the negative pin.

According to an exemplary embodiment not part of the present invention, the chip is directly soldered on a top surface of the positive pin.

In the above various exemplary embodiments of the present invention, the area of the soldering bottom surface of the positive pin of the diode adjacent to the positive wire is larger than that of the soldering bottom surface of the negative pin of the diode adjacent to the positive wire, and the chip of the diode adjacent to the positive wire is directly electrically connected to the positive pin thereof. Thereby, the heat generated by the diode adjacent to the positive wire may be quickly dissipated out of the box body through the positive wire, improving the heat dissipation performance, the current carrying capacity and the reliability of the photovoltaic junction box.

### BRIEF DESCRIPTION OF THE DRAWINGS

The above and other features of the present invention will become more apparent by describing in detail exemplary embodiments thereof with reference to the accompanying drawings, in which:
Fig.1 is an illustrative perspective view of a photovoltaic junction box in the prior art;
Fig.2 shows four terminals and three diodes arranged in the photovoltaic junction box of Fig. 1;
Fig.3 is an illustrative perspective view of a photovoltaic junction box according to the present invention;
Fig.4 shows terminals and diodes arranged in the photovoltaic junction box of Fig.3;
Fig.5 is a cross section view of a first diode shown in Fig.4;
Fig.6 is a cross section view of a second diode shown in Fig.4; and
Fig.7 is a cross section view of a third diode shown in Fig.4.

### DETAILED DESCRIPTION OF PREFERRED EMBODIMENTS OF THE INVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a photovoltaic junction box, comprising: a box body; four terminals provided in the box body; and three diodes each mounted on adjacent terminals. The four terminals comprise a first terminal directly connected to a positive wire directed into the box body and a second terminal adjacent to the first terminal. The three diodes comprise a first diode mounted on the first and second terminals, the first diode comprising a chip, a positive pin soldered on the first terminal and a negative pin soldered on the second terminal. An area of a soldering bottom surface of the positive pin of the first diode soldered onto a surface of the first terminal is larger than that of a soldering bottom surface of the negative pin of the first diode soldered onto a surface of the second terminal. The chip of the first diode is directly electrically connected to the positive pin of the first diode.

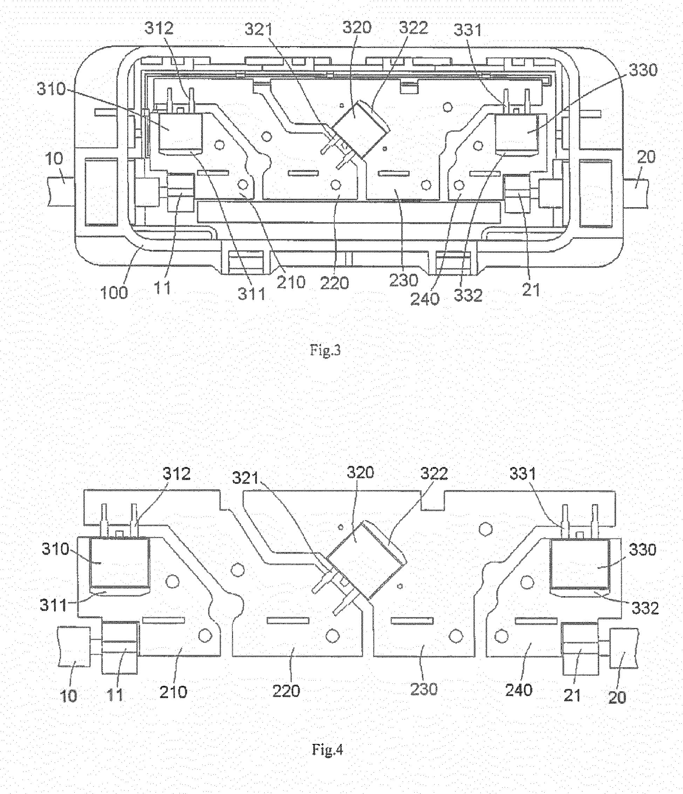

Fig.3 is an illustrative perspective view of a photovoltaic junction box according to the present invention; Fig.4 shows terminals 210, 220, 230, 240 and diodes 310, 320, 330 arranged in the photovoltaic junction box of Fig.3.

As shown in Figs.3-4, in an embodiment, the photovoltaic junction box mainly comprises a box body 100, four terminals 210, 220, 230, 240 and three diodes 310, 320, 330.

As shown in Figs.3-4, the four terminals 210, 220, 230, 240 and the three diodes 310, 320, 330 are arranged in the box body 100. Each of the three diodes 310, 320, 330 is mounted on adjacent terminals 210, 220, 230, 240.

As shown in Figs.3 and 4, in an embodiment, the four terminals 210, 220, 230, 240 comprise a first terminal 210 directly electrically connected to a positive wire 10 directed into the box body 100 and a second terminal 220 adjacent to the first terminal 210.

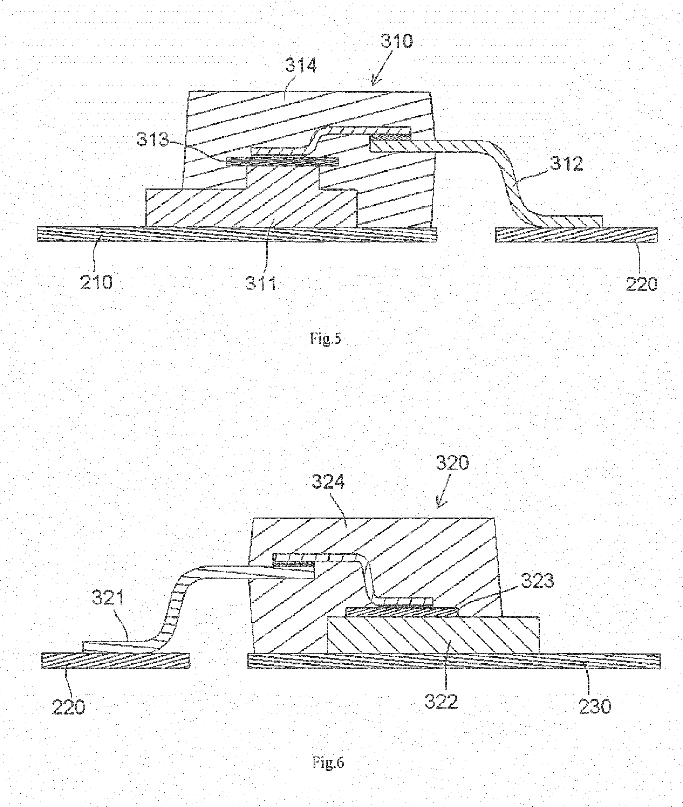

Fig.5 is a cross section view of a first diode 310 shown in Fig.4.

As shown in Figs.3-5, in an embodiment, the three diodes 310, 320, 330 comprise a first diode 310 mounted on the first terminal 210 and the second terminal 220. The first diode 310 comprises a chip 313 (see Fig.5), a positive pin 311 soldered on the first terminal 210 and a negative pin 312 soldered on the second terminal 220.

As shown in Figs.3-5, in an embodiment, the chip 313 of the first diode 310 is directly electrically connected to the positive pin 311 of the first diode 310, for example, the chip 313 of the first diode 310 is directly soldered on a top surface of the positive pin 311 of the first diode 310. An area of a soldering bottom surface of the positive pin 311 of the first diode 310, which is soldered onto a surface of the first terminal 210, is larger than an area of a soldering bottom surface of the negative pin 312 of the first diode 310, which is soldered onto a surface of the second terminal 220.

In an embodiment, the area of the soldering bottom surface of the positive pin 311 of the first diode 310, which is soldered onto the surface of the first terminal 210, may be 2-1000 times of the area of the soldering bottom surface of the negative pin 312 of the first diode 310, which is soldered onto the surface of the second terminal 220. Preferably, the area of the soldering bottom surface of the positive pin 311 of the first diode 310 soldered onto the surface of the first terminal 210 may be 10-500 times of the area of the soldering bottom surface of the negative pin 312 of the first diode 310 soldered onto the surface of the second terminal 220. More preferably, the area of the soldering bottom surface of the positive pin 311 of the first diode 310, which is soldered onto the surface of the first terminal 210, may be 20-100 times of the area of the soldering bottom surface of the negative pin 312 of the first diode 310, which is soldered onto the surface of the second terminal 220.

As shown in Figs.3-4, in an embodiment, the first diode 310 is configured to be a surface mount type diode, and it is mounted on the first terminal 210 and the second terminal 220 in a manner of SMT (Surface Mount Technology).

As shown in Figs.3-5, in an embodiment, the positive pin 311 of the first diode 310 is provided on a bottom of a package body 314 and electrically connected to the positive surface of the chip 313 of the first diode 310. The negative pin 312 of the first diode 310 is electrically connected to the negative surface of the chip 313 of the first diode 310 and extends out from a side of the package body 314.

As shown in Figs.3-5, in an embodiment, the positive pin 311 of the first diode 310 is a single welding pad, and the negative pin 312 of the first diode 310 comprises a pair of welding strips spaced from each other.

As shown in Figs.3 and 4, in an embodiment, the four terminals 210, 220, 230, 240 further comprise a third terminal 230 adjacent to the second terminal 220. The three diodes 310, 320, 330 further comprise a second diode 320 mounted on the second terminal 220 and the third terminal 230.

Fig.6 is a cross section view of a second diode 320 shown in Fig.4.

As shown in Figs.3-4 and 6, in an embodiment, the second diode 320 comprises a chip 323, a positive pin 321 soldered on the second terminal 220 and a negative pin 322 soldered on the third terminal 230. The chip 323 of the second diode 320 is directly electrically connected to the negative pin 322 of the second diode 320, for example, the chip 323 of the second diode 320 is directly soldered on a top surface of the negative pin 322 of the second diode 320. An area of a soldering bottom surface of the positive pin 321 of the second diode 320, which is soldered onto the surface of the second terminal 220, is less than an area of a soldering bottom surface of the negative pin 322 of the second diode 320, which is soldered onto a surface of the third terminal 230.

In an embodiment, the area of the soldering bottom surface of the negative pin 322 of the second diode 320 soldered onto the surface of the third terminal 230 may be 2-1000 times of the area of the soldering bottom surface of the positive pin 321 of the second diode 320 soldered onto the surface of the second terminal 220. Preferably, the area of the soldering bottom surface of the negative pin 322 of the second diode 320 soldered onto the surface of the third terminal 230 may be 10-500 times of the area of the soldering bottom surface of the positive pin 321 of the second diode 320 soldered onto the surface of the second terminal 220. More preferably, the area of the soldering bottom surface of the negative pin 322 of the second diode 320 soldered onto the surface of the third terminal 230 may be 20-100 times of the area of the soldering bottom surface of the positive pin 321 of the second diode 320 soldered onto the surface of the second terminal 220.

As shown in Figs.3-4, in an embodiment, the second diode 320 is configured to be a surface mount type diode, and it is mounted on the second terminal 220 and the third terminal 230 in a manner of SMT (Surface Mount Technology).

As shown in Figs.3-4 and 6, in an embodiment, the negative pin 322 of the second diode 320 is provided on a bottom of a package body 324 of the second diode 320 and electrically connected to the negative surface of the chip 323 of the second diode 320. The positive pin 321 of the second diode 320 is electrically connected to the positive surface of the chip 323 of the second diode 320 and extends out from a side of the package body 324.

As shown in Figs.3-4 and 6, in an embodiment, the negative pin 322 of the second diode 320 is a single welding pad, and the positive pin 321 of the second diode 320 comprises a pair of welding strips spaced from each other.

As shown in Figs.3-4, in an embodiment, the four terminals 210, 220, 230, 240 further comprise a fourth terminal 240 adjacent to the third terminal 230. The three diodes 310, 320, 330 further comprise a third diode 330 mounted on the third terminal 230 and the fourth terminal 240. A negative wire 20 directed into the box body 100 is directly electrically connected to the fourth terminal 240.

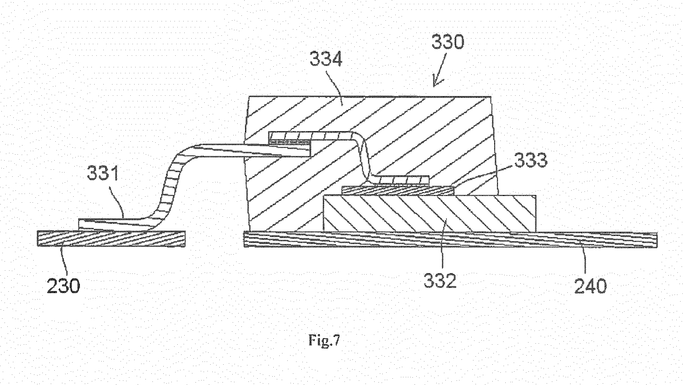

Fig.7 is a cross section view of the third diode 330 shown in Fig.4.

As shown in Figs.3-4 and 7, in an embodiment, the third diode 330 comprises a chip 333, a positive pin 331 soldered on the third terminal 230 and a negative pin 332 soldered on the fourth terminal 240. The chip 333 of the third diode 330 is directly electrically connected to the negative pin 332 of the third diode 330, for example, the chip 333 of the third diode 330 is directly soldered on a top surface of the negative pin 332 of the third diode 330. An area of a soldering bottom surface of the positive pin 331 of the third diode 330, which is soldered onto the surface of the third terminal 230, is less than an area of a soldering bottom surface of the negative pin 332 of the third diode 330, which is soldered onto a surface of the fourth terminal 240.

As shown in Figs.3-4, in an embodiment, the area of the soldering bottom surface of the negative pin 332 of the third diode 330 soldered onto the surface of the fourth terminal 240 may be 2-1000 times of the area of the soldering bottom surface of the positive pin 331 of the third diode 330 soldered onto the surface of the third terminal 230. Preferably, the area of the soldering bottom surface of the negative pin 332 of the third diode 330 soldered onto the surface of the fourth terminal 240 may be 10-500 times of the area of the soldering bottom surface of the positive pin 331 of the third diode 330 soldered onto the surface of the third terminal 230. More preferably, the area of the soldering bottom surface of the negative pin 332 of the third diode 330 soldered onto the surface of the fourth terminal 240 may be 20-100 times of the area of the soldering bottom surface of the positive pin 331 of the third diode 330 soldered onto the surface of the third terminal 230.

As shown in Figs.3-4, in an embodiment, the third diode 330 is configured to be a surface mount type diode, and it is mounted on the third terminal 230 and the fourth terminal 240 in a manner of SMT (Surface Mount Technology).

As shown in Figs.3-4 and 7, in an embodiment, the negative pin 332 of the third diode 330 is provided on a bottom of a package body 324 of the third diode 330 and electrically connected to the negative surface of the chip 333 of the third diode 330. The positive pin 331 of the third diode 330 is electrically connected to the positive surface of the chip 333 of the third diode 330 and extends out from a side of the package body 324.

As shown in Figs.3-4 and 7, in an embodiment, the negative pin 332 of the third diode 330 is a single welding pad, and the positive pin 331 of the third diode 330 comprises a pair of welding strips spaced from each other.

As shown in Figs.3-5, in an embodiment, since the conductor core 11 of the positive wire 10 is directly soldered on the first terminal 210, the heat generated by the chip 313 of the first diode 310 in use may be quickly transferred to the conductor core 11 of the positive wire 10 through the positive pin 311 and the first terminal 210. Thereby, the heat generated by the chip 313 of the first diode 310 in use may be quickly dissipated out of the box body 100 through the conductor core 11 of the positive wire 10, improving the heat dissipation performance, the current carrying capacity and the reliability of the photovoltaic junction box.

As shown in Figs.3-4 and 7, in an embodiment, since the conductor core 21 of the negative wire 20 is directly soldered on the fourth terminal 240, the heat generated by the chip 333 of the third diode 330 in use may be quickly transferred to the conductor core 21 of the negative wire 20 through the negative pin 332 and the fourth terminal 240. Thereby, the heat generated by the chip 333 of the third diode 330 in use may be quickly dissipated out of the box body 100 through the conductor core 21 of the negative wire 20, improving the heat dissipation performance, the current carrying capacity and the reliability of the photovoltaic junction box.

As shown in Figs.3-4 and 6, in an embodiment, the area of the third terminal 230 is larger than that of any one of the first terminal 210, the second terminal 220 and the fourth terminal 240. That is, in the illustrated embodiment, the third terminal 230 has the largest area in the terminals provided in the photovoltaic junction box. In this way, the heat generated by the chip 323 of the second diode 320 in use may be quickly transferred to the third terminal 230 with the largest area through the negative pin 322. Thereby, the heat generated by the chip 323 of the second diode 320 in use may be quickly dissipated out of the box body 100 through the third terminal 230 with the largest area, further improving the heat dissipation performance, the current carrying capacity and the reliability of the photovoltaic junction box.

As shown in Figs.3-4, in an embodiment, the area of the first terminal 210 is substantially equal to that of the fourth terminal 240. In the illustrated embodiment, since the heat generated by the chip 313 of the first diode 310 and the heat generated by the chip 333 of the third diode 330 may be quickly dissipated out of the box body 100 through the conductor 11 of the positive wire 10 and the conductor 21 of the negative wire 20, respectively, the first terminal 210 and the fourth terminal 240 have the smallest area in the terminals of the photovoltaic junction box.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles of the invention , the scope of which is defined in the claims.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A photovoltaic junction box, comprising:
a box body (100);
four terminals (210, 220, 230, 240) provided in the box body (100) and comprising a first terminal (210) directly connected to a positive wire (10) directed into the box body (100) and a second terminal (220) adjacent to the first terminal (210); and
three diodes (310, 320, 330) each mounted on adjacent terminals (210, 220, 230, 240), the diodes comprising a first diode (310) mounted on the first and second terminals (210, 220), the first diode (310) comprising a chip (313), a positive pin (311) soldered on the first terminal (210) and a negative pin (312) soldered on the second terminal (220),
wherein an area of a soldering bottom surface of the positive pin (311) of the first diode (310) soldered onto a surface of the first terminal (210) is larger than that of a soldering bottom surface of the negative pin (312) of the first diode (310) soldered onto a surface of the second terminal (220), and wherein the chip (313) of the first diode (310) is directly electrically connected to the positive pin (311) of the first diode (310),
wherein each of the three diodes (310, 320, 330) in the photovoltaic junction box is configured as a surface mount type diode,
wherein a third terminal (230) is arranged adjacent to the second terminal (220); wherein an area of the third terminal (230) is larger than that of the second terminal (220) and wherein the diodes (310, 320, 330) further comprise a second diode (320) mounted on the second terminal (220) and the third terminal (230), wherein the second diode (320) comprises a chip (323), a positive pin (321) soldered on the second terminal (220) and a negative pin (322) soldered on the third terminal (230), and wherein an area of a soldering bottom surface of the positive pin (321) of the second diode (320), which is soldered onto a surface of the second terminal (220), is less than an area of a soldering bottom surface of the negative pin (322) of the second diode (320) soldered onto a surface of the third terminal (230); and wherein the chip (323) of the second diode (320) is directly electrically connected to the negative pin (322) of the second diode (320),
wherein a fourth terminal (240) is arranged adjacent to the third terminal (230); wherein the diodes (310, 320, 330) further comprise a third diode (330) mounted on the third terminal (230) and the fourth terminal (240); and wherein a negative wire (20) directed into the box body (100) is electrically connected to the fourth terminal (240),
wherein the third diode (330) comprises a chip (333), a positive pin (331) soldered on the third terminal (230) and a negative pin (332) soldered on the fourth terminal (240); and wherein an area of a soldering bottom surface of the positive pin (331) of the third diode (330), which is soldered onto a surface of the third terminal (230), is less than an area of a soldering bottom surface of the negative pin (332) of the third diode (330), which is soldered onto a surface of the fourth terminal (240); and wherein the chip (333) of the third diode (330) is directly electrically connected to the negative pin (332) of the third diode (330).

2. The photovoltaic junction box according to claim 1,
wherein the chip (313) of the first diode (310) is directly soldered on a top surface of the positive pin (311) of the first diode (310).

3. The photovoltaic junction box according to claim 1,
wherein an area of the third terminal (230) is larger than that of any other one of the terminals in the photovoltaic junction box.

4. The photovoltaic junction box according to claim 1, wherein an area of the fourth terminal (240) is substantially equal to that of the first terminal (210).

## Patentansprüche

1. Photovoltaik-Anschlusskasten, der umfasst:
einen Kasten-Körper (100);
vier Anschlüsse (210, 220, 230, 240), die in dem Kasten-Körper (100) vorhanden sind und einen ersten Anschluss (210), der direkt mit einem in den Kasten-Körper (100) eingeleiteten positiven Leiter (10) verbunden ist, sowie einen zweiten Anschluss (220) umfassen, der an den ersten Anschluss (210) angrenzt; und
drei Dioden (310, 320, 330), die jeweils an benachbarten Anschlüssen (210, 220, 230, 240) angebracht sind, wobei die Dioden eine erste Diode (310) umfassen, die an dem ersten und dem zweiten Anschluss (210, 220) angebracht ist, und die erste Diode (310) einen Chip (313), einen positiven Kontaktstift (311), der an dem ersten Anschluss (210) angelötet ist, sowie einen negativen Kontaktstift (312) umfasst, der an dem zweiten Anschluss (220) angelötet ist,
wobei eine Flächenausdehnung einer unteren Lötfläche des positiven Kontaktstiftes (311) der ersten Diode (310), die an eine Oberfläche des ersten Anschlusses (210) angelötet ist, größer ist als die einer unteren Lötfläche des negativen Kontaktstiftes (312) der ersten Diode (310), die an einer Oberfläche des zweiten Anschlusses (220) angelötet ist, und der Chip (313) der ersten Diode (310) direkt elektrisch mit dem positiven Kontaktstift (311) der ersten Diode (310) verbunden ist,
wobei jede der drei Dioden (310, 320, 330) in dem Photovoltaik-Anschlusskasten als eine oberflächenmontierte Diode ausgeführt ist,
wobei ein dritter Anschluss (230) an den zweiten Anschluss (220) angrenzend angeordnet ist;
wobei eine Flächenausdehnung des dritten Anschlusses (230) größer ist als die des zweiten Anschlusses (220) und die Dioden (310, 320, 330) des Weiteren eine zweite Diode (320) umfassen, die an dem zweiten Anschluss (220) und dem dritten Anschluss (230) angebracht ist, wobei die zweite Diode (320) einen Chip (323), einen positiven Kontaktstift (321), der an dem zweiten Anschluss (220) angelötet ist, sowie einen negativen Kontaktstift (322) umfasst, der an dem dritten Anschluss (230) angelötet ist, und eine Flächenausdehnung einer unteren Lötfläche des positiven Kontaktstiftes (321) der zweiten Diode (320), die an einer Oberfläche des zweiten Anschlusses (220) angelötet ist, kleiner ist als eine Flächenausdehnung einer unteren Lötfläche des negativen Kontaktstiftes (322) der zweiten Diode (320), die an einer Oberfläche des dritten Anschlusses (230) angelötet ist, und der Chip (323) der zweiten Diode (320) direkt elektrisch mit dem negativen Kontaktstift (322) der zweiten Diode (320) verbunden ist,
wobei ein vierter Anschluss (240) an den dritten Anschluss (230) angrenzend angeordnet ist und die Dioden (310, 320, 330) des Weiteren eine dritte Diode (330) umfassen, die an dem dritten Anschluss (230) und dem vierten Anschluss (240) angebracht ist, und ein in den Kasten-Körper (100) eingeleiteter negativer Leiter (20) elektrisch mit dem vierten Anschluss (240) verbunden ist,
wobei die dritte Diode (330) einen Chip (333), einen positiven Kontaktstift (331), der an dem dritten Anschluss (230) angelötet ist, sowie einen negativen Kontaktstift (332) umfasst, der an dem vierten Anschluss (240) angelötet ist, und eine Flächenausdehnung einer unteren Lötfläche des positiven Kontaktstiftes (331) der dritten Diode (330), die an einer Oberfläche des dritten Anschlusses (230) angelötet ist, kleiner ist als eine Flächenausdehnung einer unteren Lötfläche des negativen Kontaktstiftes (332) der dritten Diode (330), die an einer Oberfläche des vierten Anschlusses (240) angelötet ist, und der Chip (333) der dritten Diode (330) direkt elektrisch mit dem negativen Kontaktstift (332) der dritten Diode (330) verbunden ist.

2. Photovoltaik-Anschlusskasten nach Anspruch 1,
wobei der Chip (313) der ersten Diode (310) direkt an einer oberen Fläche des positiven Kontaktstiftes (311) der ersten Diode (310) angelötet ist.

3. Photovoltaik-Anschlusskasten nach Anspruch 1,
wobei eine Flächenausdehnung des dritten Anschlusses (230) größer ist als die jedes anderen der Anschlüsse in dem Photovoltaik-Anschlusskasten.

4. Photovoltaik-Anschlusskasten nach Anspruch 1, wobei eine Flächenausdehnung des vierten Anschlusses (240) im Wesentlichen der des ersten Anschlusses (210) gleich ist.

## Revendications

1. Boîtier de jonction photovoltaïque, comprenant :
un corps de boîtier (100) ;
quatre bornes (210, 220, 230, 240) disposées dans le corps de boîtier (100) et comprenant une première borne (210) directement connectée à un fil positif (10) dirigé vers l'intérieur du corps de boîtier (100) et une deuxième borne (220) adjacente à la première borne (210) ; et
trois diodes (310, 320, 330) chacune montée sur des bornes adjacentes (210, 220, 230, 240), les diodes comprenant une première diode (310) montée sur les première et deuxième bornes (210, 220), la première diode (310) comprenant une puce (313), une broche positive (311) brasée sur la première borne (210) et une broche négative (312) brasée sur la deuxième borne (220),
dans lequel une zone d'une surface de fond de brasage de la broche positive (311) de la première diode (310) brasée sur une surface de la première borne (210) est plus grande que celle d'une surface de fond de brasage de la broche négative (312) de la première diode (310) brasée sur une surface de la deuxième borne (220), et dans lequel la puce (313) de la première diode (310) est connectée directement électriquement à la broche positive (311) de la première diode (310),
dans lequel chacune des trois diodes (310, 320, 330) dans le boîtier de jonction photovoltaïque est configurée en tant que diode de type monté en surface,
dans lequel une troisième borne (230) est disposée adjacente à la deuxième borne (220) ; dans lequel une zone de la troisième borne (230) est plus grande que celle de la deuxième borne (220) et dans lequel les diodes (310, 320, 330) comprennent en outre une deuxième diode (320) montée sur la deuxième borne (220) et la troisième borne (230), dans lequel la deuxième diode (320) comprend une puce (323), une broche positive (321) brasée sur la deuxième borne (220) et une broche négative (322) brasée sur la troisième borne (230), et dans lequel une zone d'une surface de fond de brasage de la broche positive (321) de la deuxième diode (320), qui est brasée sur une surface de la deuxième borne (220), est inférieure à une zone d'une surface de fond de brasage de la broche négative (322) de la deuxième diode (320) brasée sur une surface de la troisième borne (230) ; et dans lequel la puce (323) de la deuxième diode (320) est connectée directement électriquement à la broche négative (322) de la deuxième diode (320),
dans lequel une quatrième borne (240) est disposée adjacente à la troisième borne (230) ; dans lequel les diodes (310, 320, 330) comprennent en outre une troisième diode (330) montée sur la troisième borne (230) et la quatrième borne (240) ; et dans lequel un fil négatif (20) dirigé vers le corps de boîtier (100) est connecté électriquement à la quatrième borne (240),
dans lequel la troisième diode (330) comprend une puce (333), une broche positive (331) brasée sur la troisième borne (230) et une broche négative (332) brasée sur la quatrième borne (240) ; et dans lequel une zone d'une surface de fond de brasage de la broche positive (331) de la troisième diode (330), qui est brasée sur une surface de la troisième borne (230), est inférieure à une zone d'une surface de fond de brasage de la broche négative (332) de la troisième diode (330), qui est brasée sur une surface de la quatrième borne (240) ; et dans lequel la puce (333) de la troisième diode (330) est connectée directement électriquement à la broche négative (332) de la troisième diode (330).

2. Le boîtier de jonction photovoltaïque selon la revendication 1,
dans lequel la puce (313) de la deuxième diode (310) est brasée directement sur une surface supérieure de la broche positive (311) de la première diode (310).

3. Le boîtier de jonction photovoltaïque selon la revendication 1,
dans lequel une zone de la troisième borne (230) est supérieure à celle d'une quelconque autre des bornes dans le boîtier de jonction photovoltaïque.

4. Le boîtier de jonction photovoltaïque selon la revendication 1, dans lequel une zone de la quatrième borne (240) est substantiellement égale à celle de la première borne (210).
